(19) Europäisches Patentamt
European Patent Office
Office européen des brevets

(11) **EP 1 152 245 B1**

(12) **FASCICULE DE BREVET EUROPEEN**

(45) Date de publication et mention
de la délivrance du brevet:
**11.08.2010 Bulletin 2010/32**

(51) Int Cl.:
*G01P 15/00* (2006.01) *B81B 3/00* (2006.01)
*G01C 19/56* (2006.01)

(21) Numéro de dépôt: **01401050.8**

(22) Date de dépôt: **25.04.2001**

(54) **Structure mécanique micro-usinée et dispositif incorporant la structure**

Mikrogefertigte mechanische Struktur und Anordnung mit einer solchen Struktur

Micromachined mechanical structure and device using the same

(84) Etats contractants désignés:
**CH DE FI FR GB IT LI**

(30) Priorité: **28.04.2000 FR 0005487**

(43) Date de publication de la demande:
**07.11.2001 Bulletin 2001/45**

(73) Titulaires:
• **Commissariat à l'Énergie Atomique
et aux Énergies Alternatives
75015 Paris (FR)**
Etats contractants désignés:
**DE GB IT**
• **Thales
75008 Paris (FR)**
Etats contractants désignés:
**CH DE FI FR GB LI**

(72) Inventeurs:
• **Orsier, Elisabeth
38000 Grenoble (FR)**
• **Diem, Bernard
38130 Echirolles (FR)**
• **Whebe-Alause, Hélène
38000 Grenoble (FR)**
• **Lefort, Olivier
26000 Valence (FR)**

(74) Mandataire: **Brykman, Georges
Brevatome
3, rue du Docteur Lancereaux
75008 Paris (FR)**

(56) Documents cités:
**US-A- 5 025 346    US-A- 5 650 568**

**Description**

**Domaine de l'invention**

L'invention se situe dans le domaine des structures mécaniques et plus particulièrement celles qui sont micro-usinées, comprenant une masse mobile reliée par au moins une poutre ayant deux extrémités à un ancrage, la poutre ayant l'une de ses extrémités reliée à la masse mobile et l'autre extrémité reliée à l'ancrage. Elle est relative aussi à un dispositif en particulier un capteur incorporant la structure.

**Etat de la technique**

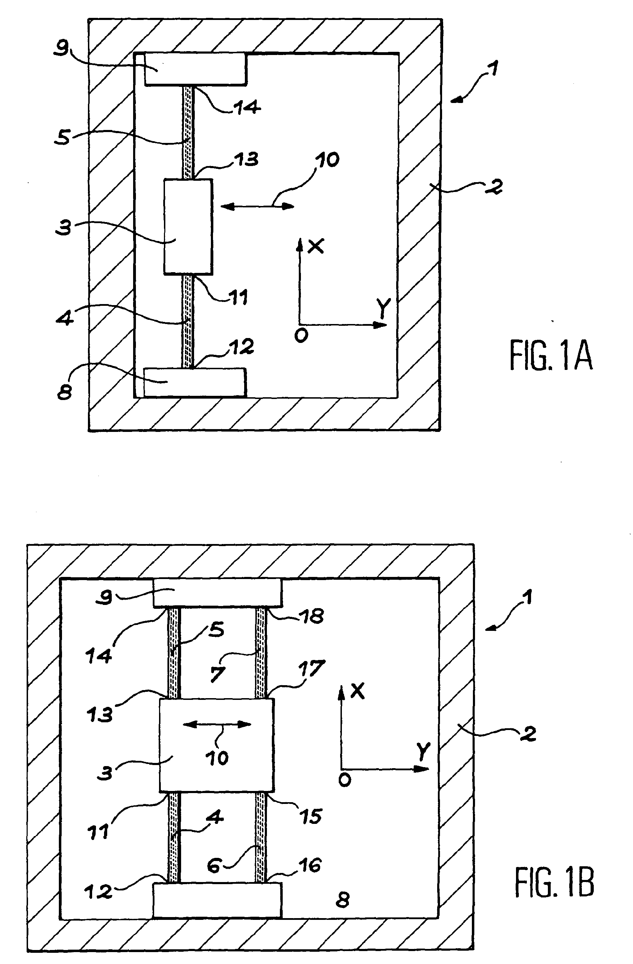

Il existe des oscillateurs mécaniques dans lesquels la force appliquée à une masse mobile et le mouvement de cette masse mobile sont liés par une relation non linéaire, dans ce cas la raideur d'une poutre couplant la masse mobile à une structure fixe de l'oscillateur est variable en fonction de l'amplitude du déplacement de la masse mobile. Cet effet de la variation de la raideur de la poutre est d'autant plus sensible que l'amplitude du mouvement de la masse mobile augmente. L'effet induit peut être sublinéaire ou supralinéaire. La relation non linéaire entre la force appliquée à la masse mobile et l'amplitude du mouvement de la masse mobile induit qu'aux fréquences proches de la résonance pour une fréquence donnée, on peut avoir deux amplitudes possibles du mouvement. Le mouvement devient donc instable. Lorsqu'une structure est excitée au voisinage de sa fréquence de résonance, l'amplitude du mouvement de la masse mobile par rapport à la position statique de la masse mobile est amplifiée par un facteur qu'on appelle "facteur de qualité Q". Ce facteur est d'autant plus fort que les pertes d'énergie dans la structure mécanique sont faibles. Cette amplification est mise à profit pour obtenir de fortes amplitudes d'oscillation avec de faibles forces d'excitation. La fonction de transfert mécanique (mouvement en fonction de la fréquence d'excitation) devient asymétrique au voisinage de la fréquence de résonance puis présente un caractère instable. Le phénomène de non linéarité de la liaison entre la force appliquée à la masse mobile et l'amplitude du mouvement de la masse mobile limite l'amplitude du mouvement que l'on peut accepter si l'on veut garder un caractère stable au mouvement. On observe par exemple des micro-structures en silicium comportant des poutres de type encastré-encastré de quelques centaines de µm de longueur dont l'oscillation devient instable pour des amplitudes de mouvement de quelques µm. Pour certains systèmes, cela limite des performances importantes, comme par exemple la sensibilité d'un dispositif de mesure incorporant une telle structure. Pour limiter le phénomène de non linéarité on a cherché à limiter l'amplitude des oscillations de la masse mobile. On reste ainsi dans le domaine linéaire et on peut avoir un mouvement stable. Ainsi, le brevet DE-202 445 2 B attribué à IBM Corp. décrit un oscillateur électromécanique monolithique comprenant une partie semi-conductrice dont la fréquence de résonance mécanique détermine la fréquence d'oscillation. Un circuit de contrôle de l'amplitude d'oscillation est intégré dans l'oscillateur. Le circuit de contrôle de l'amplitude des oscillations contrôle l'énergie d'excitation c'est-à-dire le flux de courant à travers une résistance de chauffage, en fonction d'une valeur seuil et de l'amplitude de l'oscillation réelle constatée. Un autre exemple de limitation de l'amplitude des oscillations est décrit dans le brevet SU 493 770 A attribué à KAUN POLY. Dans ce brevet, l'amplitude des vibrations est captée. Lorsque l'amplitude des vibrations dépasse un seuil prédéterminé, un moyen change la rigidité d'un système élastique de telle sorte que la fréquence de résonance est changée et donc on limite l'amplitude des vibrations. Des exemple connus de structures mécaniques incorporant une masse mobile oscillante seront maintenant décrits en référence aux figures 1A à 1D. Sur ces figures des numéros de références identiques désignent des éléments ayant les mêmes fonctions.

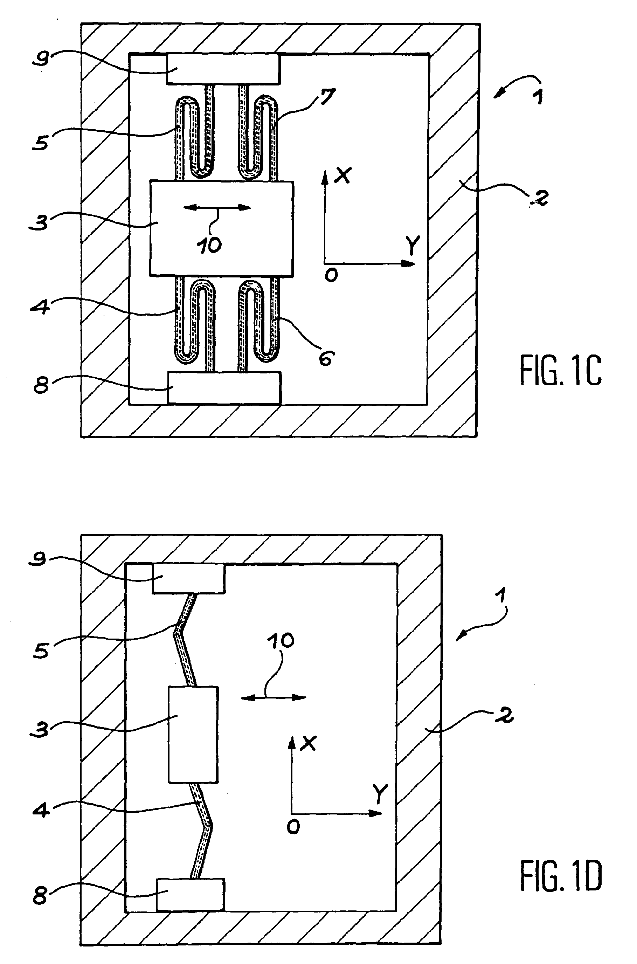

La figure 1A représente une structure mécanique 1 incorporant un cadre fixe 2 dans lequel oscille une masse mobile 3. La masse mobile 3 est reliée par l'intermédiaire de poutres 4, 5, au cadre fixe 2. La direction du mouvement représentée par une double flèche 10 est perpendiculaire aux poutres 4, 5 et se situe dans le plan XOY de la figure. Le mouvement de la masse mobile est parallèle à la direction OY. Les extrémités 11 et 12 de la poutre 4 sont reliées respectivement à la masse mobile 3 et à un ancrage 8 fixe dans la direction OY du mouvement de la masse mobile. De même, des extrémités 13, 14 de la poutre 5 sont reliées respectivement à la masse mobile et à un ancrage 9 fixe dans la direction OY. La figure 1B, représente une structure mécanique 1 comportant une masse mobile 3 comme représenté figure 1A, mais dans le cas de la figure 1B la masse mobile 3 est reliée par un ensemble de quatre poutres aux ancrages 8 et 9 respectivement, il y a donc deux poutres additionnelles 6, 7, ayant chacune des extrémités 15, 16 ; 17, 18 respectivement, ces poutres couplant la masse mobile 3 aux ancrages 8,9 respectivement. Les figures 1C et 1D représentent également une structure mécanique 1 incorporant une masse mobile 3 dans laquelle les poutres reliant la masse mobile 3 aux ancrages 8, 9 respectivement ne sont pas des poutres droites. La forme des poutres 4, 5 ou 6, 7 représentée sur les figures 1C et 1D permet une déformation de la poutre dans le plan XOY et par conséquent une plus grande amplitude des vibrations de la masse mobile 3. Cette plus grande amplitude des vibrations de la masse mobile 3 se fait sans qu'apparaissent des phénomènes non linéaires ceci en raison précisément de la forme des poutres 4, 5, 6 ou 7. Ce genre de poutres déformables que l'on peut trouver par exemple dans la demande de brevet WO 95/34798 attribuée à BOSCH présente l'inconvénient d'avoir une masse mobile 3 qui oscille non seulement dans la direction Y du plan XOY mais aussi dans la direction X de ce même plan. Il en résulte des phénomènes parasites qui viennent perturber le signal que l'on peut obtenir avec un dispositif en particulier un capteur disposant d'une telle structure mécanique. Ces phénomènes parasites peuvent se traduire par exemple par un déplacement de la fréquence de résonance, par l'apparition de modes de déformation mécanique pouvant éventuellement se coupler avec le mode d'excitation recherché dans la direction Y, et enfin par une sensibilité accrue aux accélérations suivant plusieurs axes. Dans ce dernier cas, il en résulte une réduction du contrôle de la directivité du mouvement.

Le problème de la dépendance entre l'amplitude des vibrations de la masse oscillante et la fréquence de vibration de cette masse est abordée dans le brevet US-A-5 920 012 attribué à BOEING NORTH AMERICAN.

Il est observé dans ce brevet (col. 1, lignes 44-48) que l'amplitude de la vibration peut atteindre 20 % de la longueur des poutres de suspension de la masse oscillante et que dans ces conditions, l'élongation des poutres dans leur direction axiale ne peut plus être négligée. Pour remédier à cet état de fait, il est proposé dans ce brevet (col. 1, ligne 63 - col. 2, ligne 2) de donner à la poutre de suspension une meilleure aptitude à l'élongation et pour cela de modifier la poutre ou encore la configuration du cadre ou de la masse à l'endroit où cette poutre de suspension est attachée.

Cette meilleure aptitude à l'élongation est obtenue soit :

- en donnant à chaque poutre de suspension une forme incurvée dans le plan de vibration de la masse oscillante comme représenté en figure 1 de ce brevet ; ou encore
- en prévoyant des parties permettant une relaxation de la contrainte d'élongation, par exemple sous forme de découpes effectuées au niveau des liaisons entre la poutre et le cadre fixe et/ou la masse oscillante ou encore sous forme de découpes effectuées sur la poutre d'élongation, comme représenté figure 2 à 5 de ce brevet.

On remarque que dans tous les exemples représentés, les moyens d'élongation présentent une symétrie relativement à la raideur. On veut dire par là que la résistance à l'élongation a la même valeur pour une même valeur de traction effectuée selon la ligne axiale de la poutre de suspension, exercée dans un sens ou dans le sens opposé. Exprimé autrement, la déformation des moyens d'élongation est la même que la traction soit effectuée dans un sens ou dans le sens opposé.

**Brève description de l'invention**

L'invention est telle que définie dans les revendications. L'invention vise à offrir une structure mécanique dans laquelle la masse mobile oscillante se déplace selon un axe connu sans se déplacer dans d'autres directions et ceci selon un mouvement linéaire ne présentant pas les instabilités que l'on peut observer lorsque le mouvement n'est pas linéaire. L'invention vise à offrir ce mouvement linéaire avec une amplitude d'oscillation plus importante que l'amplitude d'oscillation que l'on peut obtenir avec les structures mécaniques de l'art antérieur comme décrite par exemple dans les figures 1A et 1B ou dans le brevet Boeing 5 920 012. La conservation de la linéarité du mouvement, associée à une plus grande amplitude d'oscillation permet alors de réaliser des capteurs de mesure ayant des performances améliorées.

L'invention vise enfin à fournir une structure mécanique dans laquelle le mouvement de la masse vibratoire n'est pas ou peu sensible aux accélérations ou aux chocs selon un axe perpendiculaire à la direction du mouvement de la masse mobile.

Il est connu comme déjà expliqué plus haut que l'on sort du cadre de la mécanique linéaire lorsque la raideur des poutres tenant la masse mobile varie en fonction de l'amplitude du déplacement. Ce phénomène connu en mécanique est par exemple expliqué dans : GW Van SANTEL, "vibration mécanique, bibliothèque technique Philipps, Dunod Paris, 1957. D'autres références font état de ce phénomène comme l'illustrent les deux références suivantes : Muck-G ; Muller-G ; Kupke-W ; Nave-P ; Seidel-H , "Observation of non linear effect in the resonance behaviour of a micro-machined silicone accelerometer" in Transducers '95, 25-29 June 1995, pp 562-565, vol. 2; et Paneva-R ; Gotchev-D , "non linear vibration behaviour of thin multilayer diaphragms in Sensors and Actuators, vol. 72, no. 1, pp 79-87. Pour obtenir un mouvement linéaire, donc sans variation de la raideur, mais aussi dans une seule direction, les inventeurs ont imaginé de séparer la fonction suspension de la fonction relâchement de contraintes. Selon l'invention, la fonction relâchement de contraintes est obtenue à l'aide de moyens distincts des poutres principales telles que 4, 5, 6 ou 7 qui supportent la fonctionnalité suspension. Ces moyens qui supportent la fonction relâchement de contraintes permettent d'accroître l'amplitude de l'oscillation sans introduire des degrés de liberté susceptibles d'en modifier les autres propriétés, notamment la fréquence d'oscillation. Ces moyens permettent, de plus, de réduire la perturbation apportée au mouvement de la masse mobile oscillante par une accélération ou un choc selon une direction perpendiculaire à la direction du mouvement de la masse mobile. Le principe de l'invention est le suivant : le mouvement de la masse mobile exerce une contrainte de type élongation ou compression sur la ou les poutres qui relient la masse mobile aux ancrages. Cette variation de contraintes entraîne une variation de la raideur des poutres de liaison. Ce phénomène est peu visible dans le cas de poutres encastrées libres tant que l'extrémité libre présente le degré de liberté nécessaire à maintenir constante la raideur de la ou des poutres durant l'oscillation. Par contre, il est très important dans le cas fréquent des poutres encastrées-encastrées comme celles représentées sur les figures 1A à 1B. Le moyen de relâchement des contraintes selon l'invention présente au moins une poutre dont la géométrie section, longueur et courbure est calculée de façon à annuler la variation de raideur dans une poutre principale lors de l'oscillation de la masse mobile d'une part, et, d'autre part à introduire une dissymétrie de la réponse du moyen de relâchement de contrainte de la poutre de suspension. On veut dire par là, que contrairement aux moyens d'élongation décrits dans le brevets US-A-5 920 012 déjà cité, la raideur apparente des moyens de suspension, comprenant la poutre de suspension et son moyen d'élongation, sera dissymétrique. On veut dire par là, qu'une même force exercée selon la ligne axiale de la poutre de suspension modifiera la raideur apparente du moyen de suspension de façon différente selon que cette force est exercée dans un sens ou dans le sens opposé. Dit autrement, la déformation du moyen d'élongation sera différente pour une force de même module selon que cette force est exercée dans un sens ou dans le sens opposé. Idéalement, la variation apparente de raideur sera nulle lorsque la force est appliquée dans un sens et forte lorsque la même force est appliquée dans le sens opposé.

Grâce à cette dissymétrie de la réponse en raideur du moyens d'élongation, un capteur équipé de l'invention pourra être rendu moins sensible à une accélération selon la ligne axiale du moyen de suspension.

Dans un exemple de réalisation qui sera commenté plus en détail par la suite, le moyen de relâchement de contrainte se présente sous la forme d'une poutre. Cette poutre est fixée au moyen d'ancrage en deux points. Ces deux points définissent une droite perpendiculaire à une direction axiale du moyen de suspension. Une ligne axiale de moyen de relâchement de contrainte se présente sous la forme d'une courbe présentant une symétrie par rapport à la direction axiale du moyen de suspension mécaniquement lié à cette poutre de relâchement de contrainte en sorte que cette courbe se présente sous la forme de demi-parties symétriques l'une de l'autre. Cette courbe forme un creux dont le fond coïncide avec le point de jonction entre la poutre de suspension et la poutre de relâchement des contraintes. Chaque demi-partie symétrique présente un point d'inflexion.

Lorsque la masse mobile s'éloigne de sa position de repos, le moyen de suspension exerce une traction sur la poutre de relâchement de contrainte. La forme de cette poutre présentant un creux et un double point d'inflexion, sous l'effet de la traction exercée sur le fond du creux, la poutre tend à s'aplatir et donc à diminuer sa longueur en sorte qu'elle travaille en compression. Il en résulte, qu'au cours du mouvement oscillatoire de la masse mobile, la poutre de relâchement de contrainte selon l'invention travaille toujours en compression.

Si la poutre de suspension subit une accélération dont une composante est dirigée selon la direction axiale de la poutre de telle sorte qu'une force selon cette direction axiale est exercé sur le fond de la poutre de relâchement de contrainte sensiblement perpendiculairement à cette poutre, cette force ayant tendance à accentuer le creux formé par cette poutre, cette poutre va travailler en traction. Les inventeurs ont noté qu'avec cette forme, la raideur apparente de la poutre de relâchement de contrainte travaillant en traction est plus grande que la raideur de la même poutre travaillant en compression.

Les inventeurs utilisent cette dissymétrie de la raideur apparente selon que l'on travaille en traction ou en compression de la poutre de relâchement de contrainte pour rendre la suspension insensible, ou au minimum moins sensible aux accélérations selon la direction axiale de la poutre de suspension s'exerçant dans un sens tendant à creuser la poutre de relâchement de contrainte. Si, de plus, l'on veut rendre la suspension insensible ou moins sensible aux accélérations s'exerçant aussi dans un sens opposé au premier sens, on pourra prévoir de suspendre la masse oscillante en utilisant deux poutres de relâchement de contrainte, symétriques l'une de l'autre par rapport à un axe perpendiculaire à la direction axiale des moyens de suspension. Le moyen que l'on qualifiera par la suite de "moyen d'élongation" est connecté à la poutre principale qui constitue un "élément de suspension", à l'une au moins de ses deux extrémités, auquel cas, il constitue la liaison entre ledit élément de suspension et l'ancrage et/ou la masse mobile. Le moyen d'élongation peut aussi être connecté à l'élément de suspension au niveau d'une partition de cet élément, par exemple, si un moyen d'élongation est composé de plusieurs poutres. Selon l'invention, la déformation du moyen d'élongation va permettre un allongement de la dimension de la poutre principale et du moyen d'élongation en fonction de l'amplitude de l'oscillation. Cette déformation s'effectue sous l'influence de la traction exercée par la poutre principale sur le moyen d'élongation. Cette force de traction est telle que la contrainte exercée dans la poutre principale reste à peu près constante.

En résumé, l'invention est relative à une structure mécanique incorporant une masse, mobile selon un axe OY, cette masse mobile étant suspendue par des éléments de suspension reliés mécaniquement d'une part, à la masse mobile et, d'autre part, à des moyens d'ancrage fixes, la structure comportant relié mécaniquement à chaque élément de suspension, un moyen d'élongation inséré entre le moyen d'ancrage et la masse mobile, ce moyen formant avec l'élément de suspension un moyen de suspension amélioré ayant une première extrémité reliée au moyen d'ancrage et une seconde extrémité reliée à la masse mobile, le moyen d'élongation étant déformable dans un plan XOY, la direction OX étant la direction reliant la première à la seconde extrémité du moyen de suspension améliorée, structure caractérisée en ce que le moyen d'élongation est dissymétrique en raideur, une force de même module exercée dans la direction axiale OX provoquant une variation apparente de raideur du moyen de suspension amélioré plus faible lorsque la force est exercée dans un premier sens que lorsque cette force est exercée dans le sens opposé.

La détermination par le calcul de la forme d'un moyen mécanique remplissant cette condition de dissymétrie peut être effectuée par une simulation numérique, par la méthode des éléments finis par exemple, au moyen d'un logiciel ANSYS. La condition de dissymétrie peut se traduire dans le moyen mécanique par une dissymétrie de la forme du moyen, ou encore de sa largeur ou de son épaisseur ou d'une combinaison de ces trois dissymétries.

Selon un exemple de réalisation qui sera décrit succinctement ci-dessous et plus en détail par la suite, au moins l'un des moyens d'élongation se présente sous la forme d'au moins une poutre ayant deux extrémités et une ligne axiale formant un creux ayant un fond, cette poutre présentant une symétrie par rapport à un axe de l'élément de suspension qui lui est connecté, en sorte que ladite ligne axiale se présente sous la forme de deux demi-parties symétriques l'une de l'autre, chaque demi-partie ayant un point d'inflexion.

De façon idéale, la déformation du moyen d'élongation doit être telle que la raideur dans l'élément de suspension du moyen de suspension améliorée reste constante. Cela signifie que la force de traction ou de contraction engendrée dans l'élément de suspension par le déplacement de la masse mobile reste constante. Le moyen d'élongation a lui-même au moins deux extrémités.

Comme expliqué plus haut, l'élément de suspension est toujours couplé mécaniquement au point de symétrie, qui est donc le point milieu de l'élément de suspension.

Un moyen d'élongation peut être constitué par une ou plusieurs poutres d'élongation, de préférence identiques et parallèles entre elles.

Un élément de suspension peut être couplé à l'une de ses extrémités seulement à une poutre d'élongation, auquel cas cette poutre d'élongation constitue le moyen d'élongation, et le moyen d'élongation a alors deux extrémités qui peuvent être raccordées soit au moyen d'ancrage, soit à la masse mobile. Un élément de suspension peut aussi être couplé à chacune de ses extrémités à une poutre d'élongation auquel cas ces poutres d'élongation constituent ensemble les moyens d'élongation. Dans ce cas, les deux extrémités d'une première poutre d'élongation sont reliées mécaniquement au moyen d'ancrage et les deux extrémités de l'autre sont reliées à la masse mobile.

Enfin, les moyens d'élongation peuvent comporter un premier groupe de poutres dont les creux sont orientés dans le même sens.

De préférence, les poutres de ce groupe sont identiques et parallèles entre elles. Chaque poutre du groupe est connectée à l'élément de suspension, et les deux extrémités de chacune de ces poutres du premier groupe sont connectées au moyen d'ancrage ou à la masse oscillante.

Dans un mode avantageux de réalisation, la poutre d'élongation présente une partie rectiligne constituant le fond du creux formé par la poutre.


**Brève description des dessins**

Des exemples non limitatifs de réalisation de l'invention seront maintenant décrits en référence aux dessins annexés dans lesquels :

- les figures 1A à 1D déjà commentées représentent des exemples de réalisation d'une structure mécanique comportant une masse mobile selon l'art antérieur ;
- les figures 2 et 3 représentent des modes de réalisation de l'invention ;
- la figure 4 représente des lignes axiales d'une poutre d'élongation ;
- en l'absence de contrainte exercée en son centre par un élément de suspension,
- en présence d'une traction exercée en son centre par un élément de suspension, cette traction étant exercée dans la direction où elle tend à réduire l'importance du creux,
- la figure 5 représente des lignes axiales d'une poutre d'élongation ;
- en l'absence de contrainte exercée en son centre par un élément de suspension,
- en présence d'une poussée exercée en son centre sur le fond du creux par un élément de suspension ;
- la figure 6 représente une forme particulièrement avantageuse de ligne axiale d'une poutre d'élongation et des déformations de cette forme sous l'effet de contrainte ;
- les figures 7 et 8 montrent des exemples d'utilisation de poutres d'élongation pour constituer des moyens de suspension améliorés ;
- les figures 9 et 10 sont des courbes illustrant des modes de calcul des moyens d'élongation.


Dans les figures, les éléments ayant mêmes fonctions que les éléments déjà décrits dans les figures 1 portent le même numéro de référence que dans les figures 1.

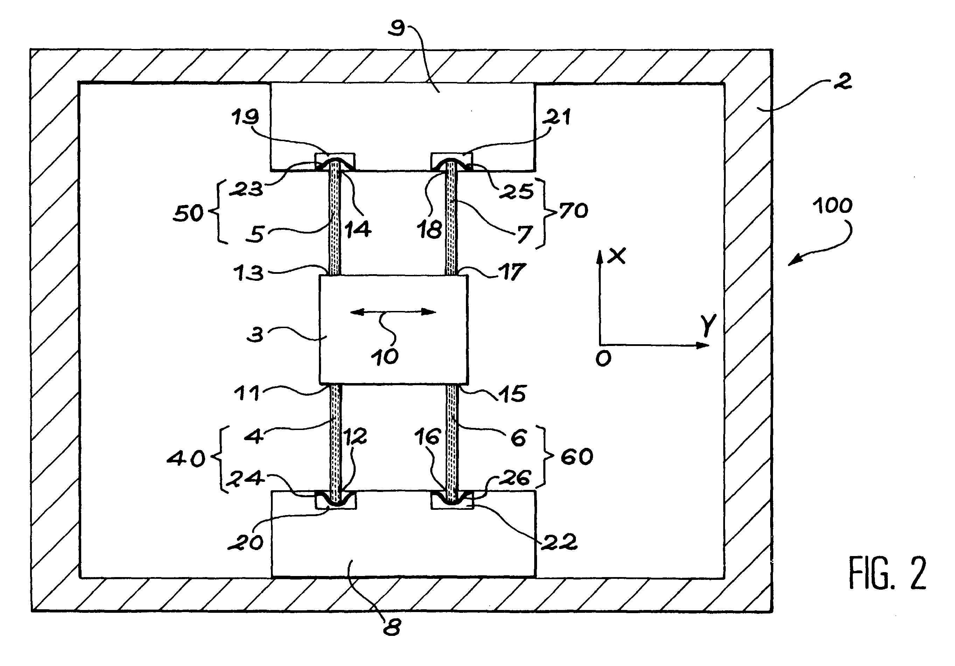

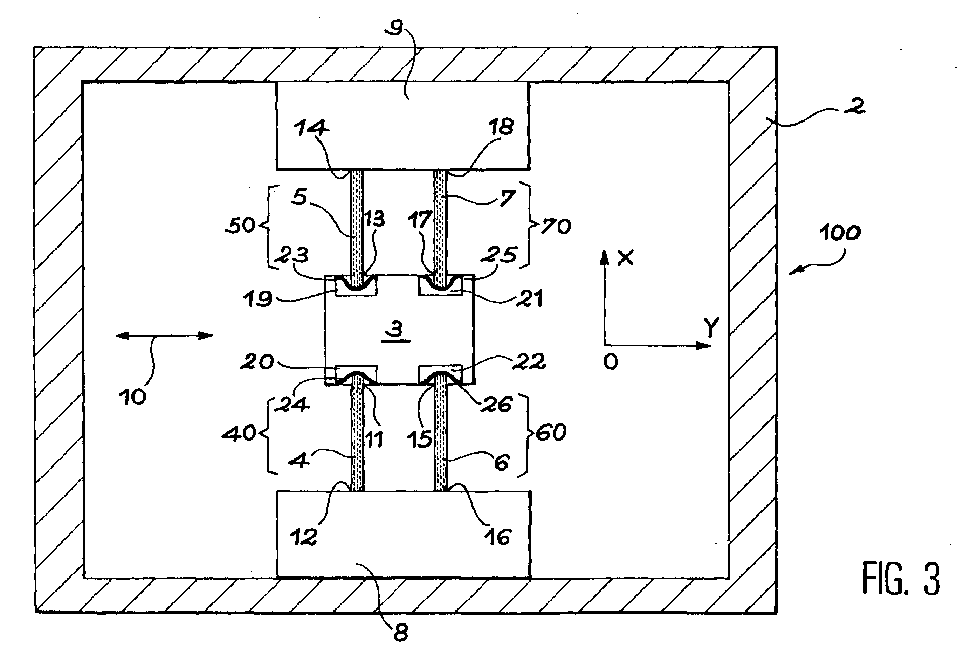

Les figures 2 et 3 représentent une structure mécanique comportant une masse mobile 3 comme celle décrite par exemple en relation avec la figure 1B. Les exemples de structures mécaniques 100 représentés sur la figure 2 se différencient de l'exemple de l'art antérieur représenté sur la figure 1B par l'ajout de moyens d'élongation 23, 25 dans l'élément d'ancrage 9 et 24, 26 dans l'élément d'ancrage 8. Par contre, dans la figure 3 les moyens d'élongation 23, 25 et 24, 26 sont incorporés au niveau de la masse mobile 3. Les moyens d'élongation 23 à 26 sont incorporés dans des évidements 19, 21 de l'ancrage 9 et 20, 22 de l'ancrage 8 pour la figure 2. Ces mêmes évidements 19 à 22 sont pratiqués au niveau de la masse mobile 3 sur la figure 3. Les moyens d'élongation des figures 2 et 3 se présentent sous la forme d'une petite poutre 23 à 26. Chacune de ces poutres a deux extrémités et les extrémités de chacune de ces poutres sont en liaison mécanique avec les bords des évidements 19 à 22 dans lesquels elles sont respectivement logées. Les déformations de ces poutres 23-26 dans le plan XOY du mouvement de la masse mobile 3 permettent un déplacement de la masse mobile sans augmentation de la contrainte présente au niveau des poutres 4 à 7 et donc permettent d'avoir un mouvement de la masse mobile 3 linéaire en fonction de l'excitation. Dans les cas représentés figures 2 et 3, les moyens d'élongation 23 à 26 sont placés à l'extrémité des éléments de suspension 4 à 7 se trouvant soit au niveau des ancrages 8 et 9 (figure 2) soit au niveau de la masse mobile 3 (figure 3). Du point de vue du calcul de la longueur et de la section des moyens d'élongation 23 à 26 il revient au même que ce moyen soit fixé dans un évidement au niveau de l'une des masses d'ancrage 8 ou 9, ou au niveau de la masse mobile 3. En règle générale, des considérations additionnelles relatives aux dimensions de la masse mobile 3 ou des points d'ancrage 8 et 9 conduiront à installer ces moyens d'élongation 23 à 26 au niveau des masses d'ancrage.

Sur les figures 2 et 3, l'élément de suspension 5 et le moyen d'élongation 23 forment ensemble un moyen de suspension amélioré 50. De même, les éléments 7-25, 4-24, et 6-26, forment ensemble respectivement des moyens de suspension améliorés 70, 40 et 60. Les extrémités des moyens de suspension améliorés 40, 50, 60 à 70 sont constituées comme suit.

Sur la figure 2, les extrémités du moyen de suspension amélioré 50 sont constituées d'une part par l'extrémité 13 de l'élément de suspension 5 raccordée à la masse mobile 3 et par les extrémités du moyen d'élongation 23 raccordées à l'évidement 19. Il en est de même pour les trois autres moyens de suspension améliorés 40, 60 et 70, l'une des extrémités de chacun de ces moyens de suspension améliorés est constituée par une extrémité d'un élément de suspension par exemple 17 pour l'élément de suspension 7, 11 pour l'élément de suspension 4 et 15 pour l'élément de suspension 6. L'autre extrémité du moyen de suspension améliorée 70 est constituée par les extrémités du moyen d'élongation 25. Il en va de même pour les moyens de suspension améliorée 40 et 60.

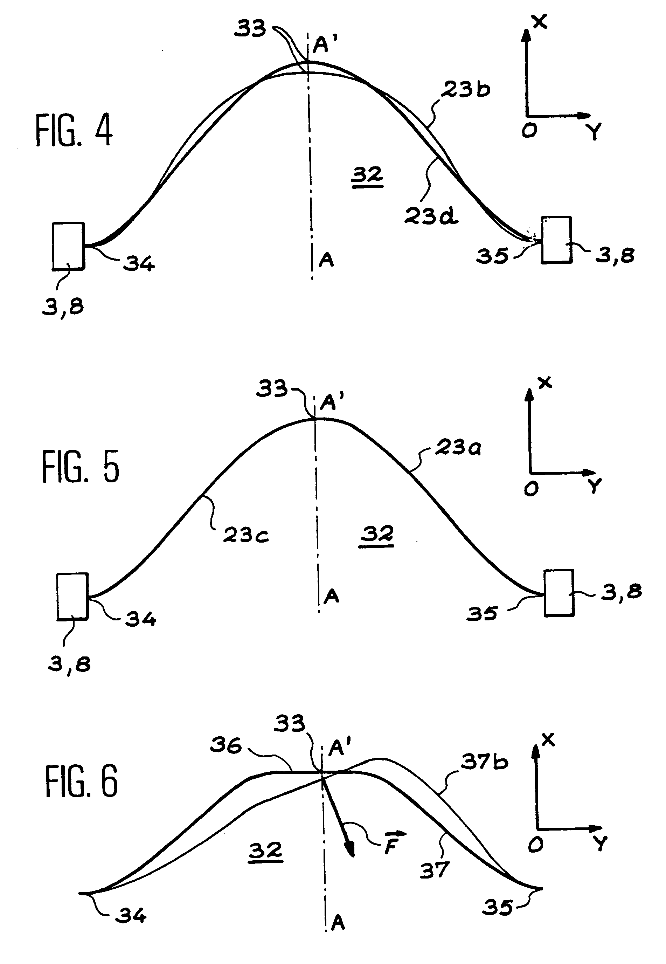

La forme et les déformations de moyens d'élongation selon l'invention seront maintenant décrits plus en détail en liaison avec les figures 4 à 6.

Ces figures représentent toutes des lignes axiales de poutres d'élongation par exemple 23, 25 telles que représentées figure 2.

Par ligne axiale, on entend une ligne située à égale distance de bords latéraux de la poutre. La poutre ayant une forme longiligne, la forme de la ligne axiale est représentative des courbures de cette poutre.

Ces lignes sont représentées dans le plan XOY de déplacement de la masse mobile 3 tel que représenté par des axes figures 2 et 3. Ces mêmes axes sont représentés sur les figures 4 à 6. La référence 23 est attribuée à chacune des courbes représentées sur les figures 4 à 6 indiquant ainsi, qu'il s'agit par exemple de la ligne axiale de la poutre 23, logée dans l'évidement 19 de la figure 2.

Chacune des courbes délimite un creux 32 tourné dans cet exemple vers les X négatifs. Chaque courbe 23 présente un axe de symétrie AA' parallèle à l'axe OX, le fond 33 du creux 32 se trouvant sur cet axe de symétrie en sorte qu'une tangente à la courbe 23 au fond du creux est parallèle à l'axe OY de déplacement de la masse oscillante 3. La tangente aux extrémités 34, 35 de la poutre 23 est, dans cet exemple, parallèle à la direction OY. L'angle de cette tangente avec la direction OY peut être compris entre 0 et 45°.

Il y a donc un point d'inflexion de la courbe 23 entre le fond du creux 33 et chacun des points extrêmes 34, 35. La figure 4 représente une première ligne axiale 23a qui est la forme de la poutre 23 en l'absence de force exercée selon une direction perpendiculaire à la tangente au fond 33 du creux 32.

Elle représente également une seconde ligne axiale 23b qui est la forme de la courbe 23 lorsqu'une traction est effectuée sur le fond 33 du creux 32 par la poutre 5 dans la direction de l'axe X et orientée, dans le cas représenté sur la figure 4, vers les X négatifs. Le creux de la courbe 23b est moins profond que celui de la courbe 23a.

La différence de profondeur est nettement perceptible, par contre les points extrêmes 34, 35 qui sont les points d'ancrage, étant les mêmes, la courbe 23b est plus renflée que la courbe 23a entre le point 33 et chacun des points 34, 35. Lorsqu'une traction dans le sens de la flèche est effectuée sur le fond 33 du creux, la poutre 33 travaille en compression..

Sur la figure 5, on a représenté également deux lignes axiales 23a et 23c. La courbe 23a représente comme sur la figure 4 la forme de la poutre 23 lorsqu'aucune force n'est exercée sur le fond du creux. La courbe 23c représente cette même forme lorsqu'une force égale et de sens opposé à celle ayant provoqué la déformation faisant passer de la courbe 23a à la courbe 23b est exercée sur le fond 33 du creux. Cette force est sur la figure 5, orientée vers les X positifs.

On voit sur la figure 5 que les courbes 23a et 23c sont pratiquement confondues l'une avec l'autre au point de ne former ensemble qu'un seul trait épais. Lorsqu'une force tendant à approfondir le creux est exercée sur le fond du creux, comme représenté figure 5, la poutre travaille en traction.

Le fait qu'une force suffisante pour déformer sensiblement la poutre, lorsque la poutre travaille en compression, est insuffisante pour faire apparaître une déformation perceptible lorsque cette même poutre travaille en traction résulte de la différence de raideur apparente de la poutre 23 lorsqu'elle travaille en compression et lorsqu'elle travaille en traction.

Il en résulte que si une accélération ou un choc est exercée sur la structure se traduisant par une force ayant une composante dirigée vers les X négatifs, cette force n'entraînera pas ou peu de déformation de la suspension. Il en résulte qu'un capteur équipé d'une telle structure sera insensible aux accélérations se traduisant par des forces exercées dans le sens des X positifs.

Si comme représenté sur les figures 2 ou 3, la masse oscillante 3 est suspendue par au moins deux éléments 4, 5 symétriques l'un de l'autre par rapport à une direction parallèle à l'axe OY et que les poutres d'élongation 23, 24 correspondantes sont de plus symétriques l'une de l'autre par rapport à ce même axe, alors une force exercée selon la direction OX, quel que soit son sens, s'exercera sur l'une des poutres 23 ou 24 pour la faire travailler en traction.

Ainsi, dans le mode de réalisation représenté figure 2 ou 3, les poutres 23-26 travaillent en compression lorsque la masse mobile 3 se déplace dans la direction OY. Deux des poutres 23-26 travaillent en traction lorsque une accélération selon OX est imprimée à la structure 100.

Une forme avantageuse de poutre d'élongation sera maintenant commentée en liaison avec la figure 6. Cette figure représente une ligne axiale 37 d'une poutre d'élongation telle que par exemple la poutre 23. Cette poutre a les mêmes caractéristiques, en particulier de dissymétrie de réponse à la traction ou la compression que celles décrites en liaison avec la description de la ligne axiale 23a. Elle a la particularité d'avoir un fond de creux 32 plat. Cela se traduit sur la ligne axiale 37 par le fait qu'elle comporte un segment central de droite 36. Les extrémités 34, 35 sont symétriques l'une de l'autre par rapport à la ligne axiale de la poutre par exemple 5.

Cette structure présente l'avantage que le segment 36 peut pivoter autour d'un axe OZ perpendiculaire au plan XOY au point 33 de croisement de la ligne axiale de la poutre 23 et de son axe de symétrie AA' pratiquement librement. Ce pivotement autour du point est illustré par la courbe 37b qui illustre la forme de la ligne axiale lorsque la poutre est sollicitée par la masse mobile lorsque cette masse a quitté sa position de repos. Cette sollicitation est représentée par une flèche $\vec{F}$.

Sur les figures 2 et 3 les moyens d'élongation 23, 26 ont chacun la forme représentée par la courbe 23a, figure 4 ou avantageusement 37, figure 6. Sur ces figures le moyen d'élongation 23-26 est soit sur les ancrages 8,9 (figure 2) soit sur la masse mobile 3 (figure 3).

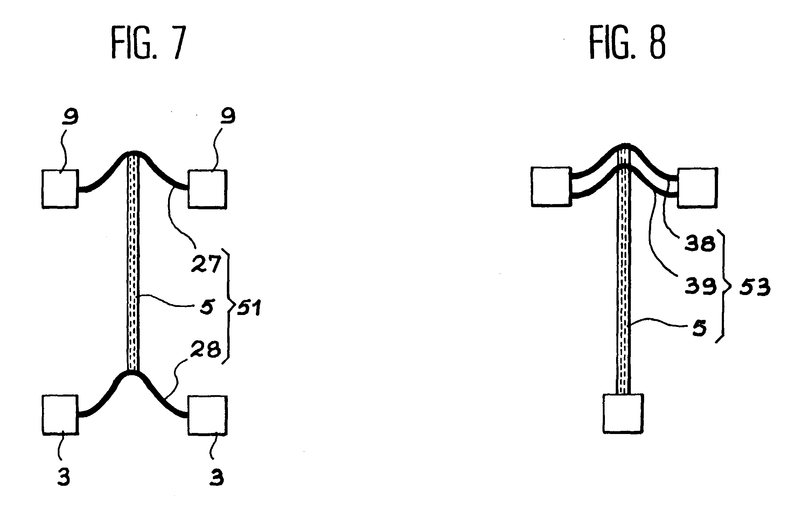

D'autres exemples d'utilisation de moyens d'élongation ayant la forme décrite en relation avec la figure 4 ou la figure 6 seront maintenant décrit en référence aux figures 7 et 8.

Pour des raisons de simplification sur les figures 7 et 8, seul l'élément de suspension améliorée 50 a été représenté sous une forme modifiée portant les références 51, 53 sur chacune des figures 7, 8 respectivement. Il convient de comprendre que le moyen de suspension amélioré 40 est construit de la même façon ou de façon symétrique par rapport à un axe parallèle à OY. De même, si la suspension comporte quatre moyens de suspension améliorés, les moyens 60 et 70 sont construits de la même façon ou de façon symétrique l'une de l'autre par rapport à un axe parallèle à OY.

Sur les figures 7 et 8, les références 3 et 9 représentant respectivement la masse oscillante et l'ancrage ont été portés sur des carrés symbolisant ces éléments.

Il convient cependant de noter que ces références 3, 9, et donc les éléments correspondants pourraient être permutés sans que le fonctionnement de la structure 100 en soit modifié.

Sur la figure 7, le moyen de suspension amélioré 51 est constitué de la poutre de suspension 5, et de deux poutres d'élongation 27, 28. Les deux extrémités de la poutre 27 sont connectées mécaniquement à l'ancrage 9. Les deux extrémités de la poutre 28 sont connectées mécaniquement à la masse oscillante 3. Dans le mode de réalisation représenté figure 7, les creux des poutres d'élongation 27, 28 sont tournés d'un même côté et la poutre de suspension 5 a l'une de ses extrémités raccordées au fond du creux de la poutre d'élongation 27 et l'autre extrémité raccordée au sommet de la bosse formant l'envers du creux de la poutre d'élongation. Un autre mode de réalisation est de tourner le creux de la poutre d'élongation de l'autre côté.

Sur la figure 8, le moyen de suspension amélioré 53 est constitué de la poutre de suspension 5, et de plusieurs poutres d'élongation dont les extrémités sont connectées par exemple à l'ancrage. Dans l'exemple représenté figure 8, il y a deux poutres 38, 39. Le point milieu de l'une des poutres d'élongation est connecté à une extrémité de la poutre 5 de suspension. Le point milieu de la seconde poutre 39 d'élongation et éventuellement de poutres additionnelles est connecté entre les deux extrémités de la poutre de suspension 5.

Compte tenu de ce qui a déjà été dit plus haut, sur les possibles symétries et similitudes, il convient de comprendre que de telles configurations avec plusieurs poutres d'élongation à une extrémité peuvent être utilisés comme dans les cas décrits en relation avec les figures 2, 3, et 7, un ensemble de plusieurs poutres remplaçant l'une au moins des poutres uniques 23-30. Ainsi, un premier groupe de poutres telles que les poutres 38, 39 représentées à titre d'exemple figure 8 peut remplacer chacune des poutres d'élongation uniques telles que 27, représentées figures 7. Un moyen de suspension amélioré tel que le moyen 51 peut également comporter un second groupe de poutres, ces groupes ayant par exemple même forme et même orientation de creux que la poutre 28 représenté figure 7.

Dans tous les exemples de réalisation présentés sur les figures 2, 3 et 7, 8, les moyens d'élongation 23-28 et 38, 39 ont en commun d'être déformables compte tenu des forces qui leur sont appliquées, dans le plan XOY défini d'une part, par la direction des mouvements de la masse mobile 3 et, d'autre part, par la direction des éléments de suspension 4, 5, 6, 7. Les moyens d'élongation 23-28 et 37-39 permettent de relâcher les contraintes induites dans les éléments de suspension comme l'élément 4 sans perturber les caractéristiques du mouvement de la masse mobile et ceci pour des déplacements beaucoup plus importants que ceux autorisés sans ce moyen. Le moyen d'élongation 23-28 et 36, 38, 39 n'introduit pas de mode parasite proche de la résonance du système. Il ne perturbe quasiment pas la fréquence propre du mouvement : le degré de liberté supplémentaire introduit par le moyen d'élongation est efficace en n'ajoutant que très peu de souplesse dans le système complet. Il faut comprendre que des moyens de relâchement de contrainte sous forme de moyens d'élongation 23-28 et 37-39 doivent être ajoutés à chacune des poutres subissant une contrainte lors du déplacement d'une masse mobile du système complet. Les non linéarités en sont nettement affaiblies et la limite d'amplitude du mouvement de la masse mobile permettant de conserver la linéarité est alors repoussée. L'invention permet d'augmenter l'amplitude du mouvement de la masse mobile de plusieurs ordres de grandeurs. La géométrie de la ou des poutres qui constitue le moyen d'élongation peut être diverse comme par exemple de section rectangulaire ou ronde constante sur toute la longueur de la poutre, la dissymétrie de raideur étant introduite comme dans les exemples commentés en liaison avec les figures 2 à 8 par la forme de la ligne axiale. Comme expliqué plus haut, cette dissymétrie de raideur peut également être obtenue par des variations de la forme de la section droite du moyen d'élongation entre sa première et sa seconde extrémités. Les moyens d'élongation selon l'invention ont en outre l'avantage d'être insensibles aux accélérations perpendiculaires au mouvement de la masse oscillante.

La démarche à suivre pour dimensionner le moyen d'élongation est expliquée maintenant.

La raideur élastique du moyen d'élongation est calculée de façon à ce que la déformation du moyen d'élongation au cours du mouvement de la masse mobile évite l'apparition d'une trop forte variation de raideur dans l'élément ou les éléments de suspension amélioré(s) sous l'effet de la contrainte appliquée audit élément de suspension. Tout d'abord on évalue l'effet de la contrainte induite dans chacun des éléments de suspension qui soutiennent la masse mobile lors du mouvement d'oscillation de cette masse et lorsqu'aucun moyen d'élongation n'est utilisé. Cette contrainte est facilement calculée en appliquant les relations classiques de la résistance des matériaux et dépend de la géométrie des éléments de suspension.

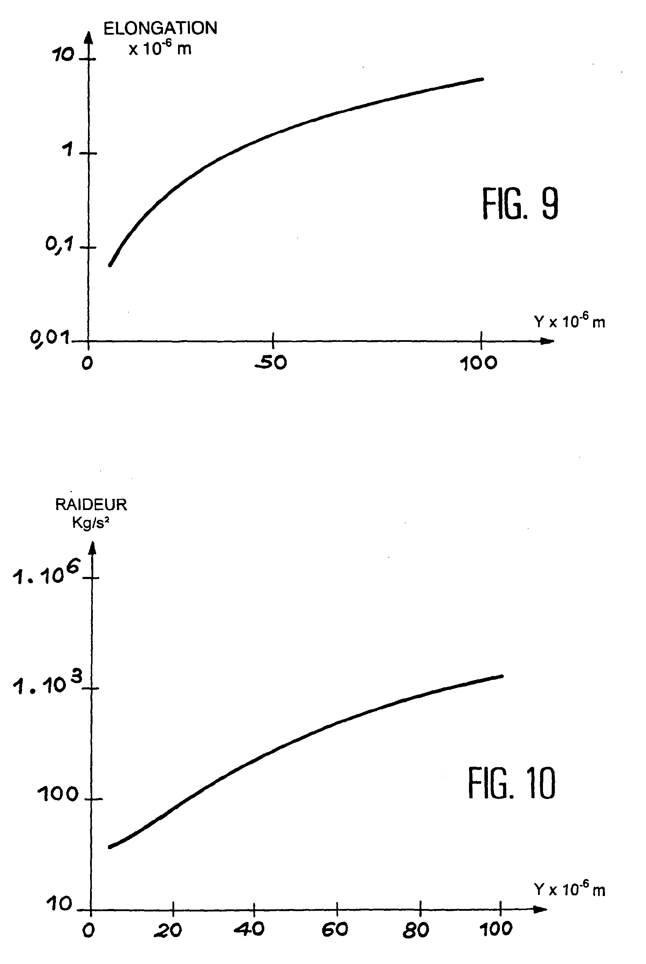

La figure 9 représente dans le cas d'une poutre de section rectangulaire et de type encastré-encastré constituant un élément de suspension pour une masse mobile, oscillant suivant l'axe Y, l'évolution de la déformation de la poutre constituant l'élément de suspension suivant l'axe X en fonction de l'amplitude d'oscillation suivant Y. L'amplitude de l'oscillation de la masse mobile est portée en abscisse alors qu'en ordonnée on a l'élongation du moyen de suspension exprimé en $\mu$m. A partir de la valeur de la déformation, et dans le cas d'une poutre indéformable suivant sa longueur (direction X) et ne possédant pas de moyen d'élongation, la figure 10 représente l'évolution de la raideur équivalente de la poutre. On a porté en abscisse l'amplitude de l'oscillation et en ordonnée, la raideur exprimée en $Kg/s^2$. On détermine la raideur du moyen d'élongation de façon à ce que sa déformation soit d'une dimension comparable à la valeur de l'élongation telle que déterminée et représentée au moyen de la courbe représentée figure 9. Une fois encore ces calculs de la valeur de la raideur s'appuient sur les lois classiques de la résistance des matériaux. Le dimensionnement du moyen d'élongation doit également prendre en compte que la déformation de ce moyen doit rester telle qu'elle ne provoque pas une variation importante de la raideur de celui-ci. Il s'agit là d'une limitation de la capacité du moyen d'élongation à favoriser des amplitudes d'oscillation de la masse mobile encore plus importantes. Dans le cas particulier tel que représenté figure 1A ou figure 1B où la suspension en l'absence du moyen d'élongation est constitué par une ou plusieurs poutres de type encastré-encastré l'équation du mouvement de la masse mobile peut s'exprimer sous la forme générale bien connue :

$$\frac{d^2Y}{dt^2} + 2\lambda \frac{dY}{dt} + \omega_0^2 Y + \alpha Y^2 + \beta Y^3 = F_0 \sin \omega t$$

Dans cette équation Y représente l'élongation du mouvement de la masse mobile, t représente le temps, $\lambda$ représente un coefficient d'amortissement, $\omega_0$ représente la fréquence de résonance et $\alpha$ et $\beta$ sont des coefficients de non linéarité. $F_0$ représente la force appliquée. Les coefficients $\alpha$ et $\beta$ sont choisis tels que $\alpha Y_{max}$ est très inférieur à $\omega_0^2$ et $\beta Y^2_{max}$ est très inférieur à $\omega_0^2$. De façon connue, un mouvement ayant cette équation devient instable lorsque l'amplitude du mouvement dépasse la valeur limite donnée par la formulation suivante :

$$Y_\ell{}^2 = \frac{32}{9\sqrt{3}} \cdot \frac{\omega_0{}^2}{|\beta|Q}$$

Dans cette équation $Y\ell$ est la valeur limite de l'amplitude d'oscillation et Q est égal à $\frac{\omega_0}{2\lambda} \cdot$ . Q représente le facteur de qualité mécanique de la structure. Si l'on veut rendre linéaire l'équation du mouvement de la masse mobile, il faut ajouter un moyen d'élongation tel que les coefficients $\alpha$ et $\beta$ de l'équation vont être nuls ou très faibles. Le coefficient $\alpha$ peut être considéré comme négligeable, on va donc chercher à minimiser le coefficient $\beta$. Il convient que le coefficient $\beta$ du moyen de suspension améliorée constitué d'une part, par l'élément de suspension et, d'autre part par le moyen d'élongation soit aussi petit que possible. Pour les exemples représentés sur l'une des figures 2, 3 et 7, 8, dans lesquels les poutres sont de section rectangulaire et de type encastré-encastré, la valeur du coefficient $\beta$ de la poutre équivalente formée par le moyen d'élongation et le moyen de suspension est proportionnelle à $\frac{WH}{L^3} \cdot$ W,H et L représentent respectivement les largeur, hauteur et longueur de la poutre équivalente qui suspend la masse mobile. Quand plusieurs poutres soutiennent la masse mobile on applique les règles classiques de superposition pour déterminer la poutre équivalente. Dans les exemples de réalisation tels que représentés sur les figures 2, 3 et 7, 8, le moyen d'élongation se présente sous la forme d'une poutre unique ayant ses deux extrémités reliées à un élément mécanique qui peut être considéré comme fixe par rapport au mouvement de la masse mobile. Cet élément mécanique 23 à 28 ou 36, 38, 39 est lui-même relié au support fixe du système ou à la masse mobile. Lorsque l'élément de suspension est constitué, par exemple, par une poutre principale dont la longueur est de l'ordre du mm, cette poutre ne permettant une oscillation de l'élément mobile que de quelques $\mu$m lorsque le facteur de qualité Q est élevé (supérieur à quelques centaines), le moyen d'élongation utilisé par exemple à une extrémité au moins de chacune des poutres principales peut présenter une section équivalente à la section des poutres principales. Une longueur de quelques centaines de $\mu$m du moyen d'élongation permet d'obtenir des oscillations de quelques dizaines de $\mu$m, soit une amélioration de l'amplitude d'oscillation de plusieurs ordres de grandeur.

Il en résulte qu'un capteur, par exemple un accélérateur, un gyromètre, un pressostat incorporant une structure mécanique 100 selon l'invention présentera une sensibilité et une discrimination améliorées.

## Revendications

**1.** Structure mécanique (100) incorporant au moins une masse mobile (3) selon un axe OY, cette masse mobile étant suspendue par des éléments (4,5,6,7) de suspension reliés mécaniquement d'une part, à la masse mobile (3) et, d'autre part, à des moyens d'ancrage (8,9) fixes, la structure (100) comportant relié à chaque élément (4,5,6,7) de suspension, un moyen d'élongation (23-28 ; 37-39) inséré entre le moyen d'ancrage (8,9) et la masse mobile (3), ce moyen (23-28 ; 37-39) formant avec l'élément de suspension (4,5,6,7) un moyen (40,50-53,60,70) de suspension amélioré ayant des premières extrémités reliées mécaniquement au moyen d'ancrage (8,9) et des secondes extrémités reliées à la masse mobile (3), le moyen d'élongation (23-28) étant déformable dans un plan XOY, la direction OX étant la direction reliant la première à la seconde extrémité du moyen (40,50-53,60,70) de suspension améliorée, structure **caractérisée en ce que** le moyen d'élongation se présente sous la forme d'une poutre dont les extrémités sont fixées mécaniquement soit aux dits moyens d'ancrage, soit à la masse mobile, de sorte que le moyen d'élongation est dissymétrique en raideur, une force de même module exercée dans la direction axiale OX provoquant une variation apparente de raideur du moyen de suspension amélioré plus faible lorsque la force est exercée dans un premier sens que lorsque cette force est exercée dans le sens opposé.

**2.** Structure (100) selon la revendication 1, **caractérisée en ce que** ladite poutre présente une ligne axiale (36) formant un creux (32) ayant un fond (33), cette poutre (23-28 ; 37-39) présentant une symétrie par rapport à un axe (AA') de l'élément de suspension (4-7) qui lui est connecté, en sorte que ladite ligne axiale (36) se présente sous la forme de deux demi-parties symétriques l'une de l'autre, chaque demi-partie ayant un point d'inflexion.

**3.** Structure (100) selon la revendication 2, **caractérisée en ce que** la tangente à la ligne axiale (36) à chacune de ses extrémités (34,35) fait un angle compris entre 0 et 45 DEG avec une direction perpendiculaire à l'axe de symétrie (AA') de la ligne axiale.

4.  Structure (100) selon la revendication 2 ou 3, **caractérisée en ce que** la tangente à la ligne axiale (36) au point d'intersection (33) de cette ligne avec l'axe de symétrie est perpendiculaire à l'axe de symétrie (AA').

5.  Structure (100) selon la revendication 2, **caractérisée en ce qu'**un moyen (23-28, 37-39) d'élongation est connecté à l'ancrage et **en ce qu'**un moyen d'élongation (23-30; 37-39) est connecté à la masse mobile (3).

6.  Structure (100) selon la revendication 5, **caractérisée en ce qu'**un moyen d'élongation (23-28, 37-39) est composé de plusieurs poutres d'élongation (38, 39).

7.  Structure (100) selon la revendication 1 ou 2, **caractérisée en ce qu'**elle comporte deux moyens de suspension améliorés (23-28, 37-39) symétriques l'un de l'autre par rapport à un axe.

8.  Structure (100) selon la revendication 1, **caractérisée en ce qu'**elle comporte quatre moyens (23-28, 37-39) de suspension améliorés symétriques l'un de l'autre deux à deux.

9.  Structure (100) selon la revendication 2, **caractérisée en ce que** la ligne axiale (36) de l'un au moins des moyens d'élongation (37) présente un creux (32) dont le fond (33, 36) est constitué par un segment de droite (36).

10. Dispositif, en particulier capteur incorporant une structure mécanique selon l'une des revendications 1 à 9.

**Claims**

1.  Mechanical structure (100) comprising at least a moving mass (3) moving along an OY axis, this moving mass being suspended by suspension elements (4, 5, 6, 7) mechanically connected firstly to the moving mass (3) and secondly to fixed anchor means (8, 9), the structure (100) comprising an elongation means (23-28; 37-39) inserted between the anchor means (8, 9) and the moving mass (3) and connected to each suspension element (4, 5, 6, 7), this means (23-28; 37-39) co-operating with the suspension element (4, 5, 6, 7) to form an improved suspension means (40, 50-53, 60, 70), with first ends mechanically connected to the anchor means (8, 9) and second ends connected to the moving mass (3), the elongation means (23-28) being deformable in an XOY plane, the direction OX being the direction connecting the first end to the second end of the improved suspension means (40, 50-53, 60, 70), structure **characterised in that** the elongation means is in form of a beam the ends thereof are fixed either to said anchor means or to said moving mass, so that the stiffness of the elongation means is asymmetric, an applied force causing a lower apparent stiffness variation when it is exerted in one direction along the OX axis than when the same force is applied in the opposite direction.

2.  Structure (100) according to claim 1, **characterised in that** said beam has an axial line (32) with a hollow (32) with a bottom (33), this beam (23-28; 37-39) being symmetrical with respect to an axis (AA') of the suspension element (4-7) connected to it, such that the said axial line (36) is in the form of two half parts symmetrical with each other, each half part having a point of inflection.

3.  Structure (100) according to claim 2, **characterised in that** the tangent to the axial line (36) at each of its ends (34, 35) forms an angle of between 0 and 45˚ with a direction perpendicular to the axis of symmetry (AA') of the axial line.

4.  Structure (100) according to claim 2 or 3, **characterised in that** the tangent to the axial line (36) at the point of intersection (33) of this line with the axis of symmetry is perpendicular to the axis of symmetry (AA')

5.  Structure (100) according to claim 2, **characterised in that** an elongation means (23-28, 37-39) is connected to the anchor, and **in that** an elongation means (23-30, 37-39) is connected to the moving mass (3)

6.  Structure (100) according to claim 5, **characterised in that** an elongation means (23-28, 37-39) is composed of several elongation beams (38, 39)

7.  Structure (100) according to claim 1 or 2, **characterised in that** it comprises two improved suspension means (23-28, 37-39) symmetrical with each other about an axis.

**8.** Structure (100) according to claim 1, **characterised in that** it comprises four improved suspension means (23-28, 37-39) symmetrical with each other in pairs.

**9.** Structure (100) according to claim 2, **characterised in that** the axial line (36) of at least one of the elongation means (37) is in the form of a hollow (32), the bottom (33, 36) of which consists of a straight line segment (36)

**10.** Device, and particularly a sensor, incorporating a mechanical structure according to any one of claims 1 to 9.

**Patentansprüche**

**1.** Mechanische Struktur (100), wenigstens eine gemäß einer Achse 0Y bewegliche Masse (3) umfassend, wobei diese bewegliche Masse durch Federungselemente (4, 5, 6, 7) aufgehängt ist, die mechanisch verbunden sind, einerseits durch die bewegliche Masse (3) und andrerseits durch befestigte Verankerungseinrichtungen (8, 9), und dabei jedes Federungselement (4, 5, 6, 7) der Struktur (100) mit einer Dehnungseinrichtung (23-28 ; 37-39) verbunden ist, eingefügt zwischen der Verankerungseinrichtung (8, 9) und der beweglichen Masse (3), wobei diese Einrichtung (23-28 ; 37-39) mit dem Federungselement (4, 5, 6, 7) eine verbesserte Federungseinrichtung (40, 50-53, 60, 70) bildet, von der erste Enden mechanisch mit der Verankerungseinrichtung (8, 9) verbunden sind und zweite Enden mit der beweglichen Masse (3) verbunden sind, wobei die Dehnungseinrichtungen (23-28) in einer X0Y-Ebene verformbar sind und dabei die 0X-Richtung die Richtung ist, die das erste und das zweite Ende der verbesserten Federungseinrichtung (40, 50-53, 60, 70) verbindet,
Struktur, **dadurch gekennzeichnet, dass** die Dehnungseinrichtung sich in Form eines Trägers präsentiert, dessen Enden entweder an den genannten Verankerungseinrichtungen oder an der beweglichen Masse mechanisch so befestigt sind, dass die Dehnungseinrichtung asymmetrisch steif ist, so dass eine Kraft gleichen Moduls, wirksam in der 0X-Achsenrichtung, eine Veränderung der Scheinsteifigkeit der verbesserten Federungseinrichtung verursacht, die, wenn die Kraft in einer ersten Richtung wirkt, kleiner ist als wenn diese Kraft in der entgegengesetzten Richtung wirkt.

**2.** Struktur (100) nach Anspruch 1, **dadurch gekennzeichnet, dass** der genannte Träger eine axiale Linie (36) aufweist, die eine Delle (32) mit einem Boden (33) bildet, wobei dieser Träger (23-28 ; 37-39) eine Symmetrie in Bezug auf eine Achse (AA') des Federungselements (4-7) aufweist, das mit ihm verbunden ist, so dass die genannte axiale Linie (36) sich in Form von zwei zueinander symmetrischen Halbteilen präsentiert, wobei jeder Halbteil einen Knickpunkt bzw. Biegungspunkt hat.

**3.** Struktur (100) nach Anspruch 2, **dadurch gekennzeichnet, dass** die Tangente zu der axialen Linie (36) an jedem ihrer Enden (34, 35) mit einer zu der Symmetrieachse (AA') der axialen Linie senkrechten Richtung einen zwischen 0 und 45 Grad enthaltenen Winkel bildet.

**4.** Struktur (100) nach Anspruch 2 oder 3, **dadurch gekennzeichnet, dass** die Tangente zu der axialen Linie (36) im Kreuzungspunkt (33) dieser Linie mit der Symmetrieachse senkrecht ist zur Symmetrieachse (AA').

**5.** Struktur (100) nach Anspruch 2, **dadurch gekennzeichnet, dass** eine Dehnungseinrichtung (23-28 ; 37-39) mit der Verankerung verbunden ist, und dass eine Dehnungseinrichtung (23-30 ; 37-39) mit der beweglichen Masse (3) verbunden ist.

**6.** Struktur (100) nach Anspruch 5, **dadurch gekennzeichnet, dass** eine Dehnungseinrichtung (23-28 ; 37-39) durch mehrere Dehnungsträger (38, 39) gebildet wird.

**7.** Struktur (100) nach Anspruch 1 oder 2, **dadurch gekennzeichnet, dass** sie zwei bezüglich einer Achse zueinander symmetrische verbesserte Federungseinrichtungen (23-28 ; 37-39) umfasst.

**8.** Struktur (100) nach Anspruch 1, **dadurch gekennzeichnet, dass** sie vier verbesserte Federungseinrichtungen (23-28 ; 37-39) umfasst, die paarweise zueinander symmetrisch sind.

**9.** Struktur (100) nach Anspruch 2, **dadurch gekennzeichnet, dass** die axiale Linie (36) von wenigstens einer der Dehnungseinrichtungen (37) eine Delle (32) aufweist, deren Boden (33, 36) durch ein Geradenabschnitt (36) gebildet wird.

**10.** Vorrichtung, insbesondere ein eine mechanische Struktur nach einem der Ansprüche 1 bis 9 umfassender Sensor.

FIG. 1A

FIG. 1B

FIG. 1C

FIG. 1D

FIG. 2

EP 1 152 245 B1

FIG. 3

FIG. 4

FIG. 5

FIG. 6

# FIG. 7

9    9

27
5  } 51
28

3    3

# FIG. 8

38
39 } 53
5

EP 1 152 245 B1

ELONGATION
x 10⁻⁶ m

FIG. 9

Y x 10⁻⁶ m

RAIDEUR
Kg/s²

FIG. 10

Y x 10⁻⁶ m

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 2024452 B
- SU 493770 A
- WO 9534798 A
- US 5920012 A

**Littérature non-brevet citée dans la description**

- **Muck-G ; Muller-G ; Kupke-W ; Nave-P ; Seidel-H.** Observation of non linear effect in the resonance behaviour of a micro-machined silicone accelerometer. *Transducers,* 1995, vol. 2, 562-565
- **Paneva-R ; Gotchev-D.** *non linear vibration behaviour of thin multilayer diaphragms in Sensors and Actuators,* vol. 72 (1), 79-87